Europäisches Patentamt

European Patent Office

Office européen des brevets

(11) Veröffentlichungsnummer: **0 453 590 A1**

## EUROPÄISCHE PATENTANMELDUNG

(21) Anmeldenummer: 90107695.0

(51) Int. Cl.5: **H01L 39/24**

(22) Anmeldetag: **24.04.90**

(43) Veröffentlichungstag der Anmeldung:
**30.10.91 Patentblatt 91/44**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Zorn, Gerhard, Dr.**
**Leutholdstrasse 4**
**W-8000 München 83(DE)**
Erfinder: **Wersing, Wolfram, Dipl.-Phys.**
**Weideweg 14**
**W-8011 Kirchheim(DE)**
Erfinder: **Seebacher, Bärbel, Dipl.-Phys.**
**Tegernseerstrasse 39e**
**W-8150 Holzkirchen(DE)**

(54) Verfahren zur Herstellung einer texturierten, supraleitenden Keramikschicht.

(57) Auf einem Substrat (1) wird eine Schicht (2) erzeugt, die eine unter Umständen bereits vorreagierte Mischung aus Grundsubstanzen für die Keramikschicht (3) und einem Salz enthält. Das Salz hat in der Mischung eine geringere Schmelztemperatur als im Reinzustand und als es der Zersetzungstemperatur vorgegebener Phasen entspricht. Die Schicht (2) wird auf eine Reaktionstemperatur erhitzt, die zwischen der Schmelztemperatur des Salzes und der bekannten Reaktionstemperatur der Grundsubstanzen liegt und bei der die Schmelze des Salzes bereits flüchtig ist. In der Salzschmelze entstehen die gewünschten Kristallite orientiert. Durch Abkühlung bzw. mehrfaches Aufheizen und Abkühlen werden die Eigenschaften der erzeugten supraleitenden Keramikschicht (3) optimiert.

FIG 1

FIG 2

EP 0 453 590 A1

Die Erfindung betrifft ein Verfahren zur Herstellung einer texturierten, supraleitenden Keramikschicht vorgegebener Phasen.

Für die technische Verwendung supraleitender Keramikschichten ist eine Orientierung der in den Schichten enthaltenen Kristallite nach bestimmten kristallographischen Richtungen von Bedeutung. Orientierte Schichten stellen in ihren physikalischen Eigenschaften einen Schritt in Richtung Einkristall dar. Sie zeigen zum Teil die Anisotropie des entsprechenden Einkristalls. Sie sind aber im allgemeinen wesentlich einfacher herzustellen als dieser Einkristall.

Aus DE 38 20 809 und DE 38 32 761 ist ein Verfahren zur Herstellung texturierter, supraleitender Keramikschichten bekannt. Dabei wird auf einem Substrat eine Schicht aus Rohmaterialien oder vorreagiertem Material für die supraleitende Keramikschicht aufgebracht. Das Substrat wird auf die Kristallisationstemperatur der angestrebten supraleitenden Phase der Keramik geheizt. Durch eine zusätzliche Heizung wird die Schicht kurzzeitig über die Schmelztemperatur aufgeheizt. Dadurch bildet sich eine Schmelze der Rohmaterialien. In der Schmelze findet ein beschleunigter Stofftransport statt, so daß eine Durchmischung der Elemente des Rohmaterials nach kurzer Zeit, typischerweise Sekunden bis Minuten, erreicht ist. Bei Unterschreiten der Kristallisationstemperatur kristallisieren aus der Schmelze plättchenförmige Kristallite der jeweils vorgegebenen supraleitenden Phase aus. Diese Kristallite schwimmen mit der kristallographischen c-Achse senkrecht zur Oberfläche des Substrats in der Schmelze. Beim Abkühlen bleibt diese Orientierung der wachsenden Kristallite (001-Textur) erhalten.

Für den Erhalt der chemischen Stöchiometrie bei der Kristallisation aus der Schmelze ist es wichtig, Reaktionen der Schmelze mit dem Substrat zu vermeiden. In den oben genannten Herstellverfahren wird diese Bedingung dadurch erfüllt, daß das Material nur kurze Zeit im Schmelzzustand gehalten wird.

Der Erfindung liegt die Aufgabe zugrunde, ein weiteres Verfahren zur Herstellung texturierter, supraleitender Keramikschichten anzugeben, bei dem auch lange Temperungszeiten zulässig sind und bei dem der Materialverlust in der Schicht durch Abdampfen minimiert ist.

Die Aufgabe wird erfindungsgemäß gelöst durch ein Verfahren zur Herstellung einer texturierten, supraleitenden Keramikschicht vorgegebener Phasen, bei dem die supraleitende Keramikschicht durch Kristallisation aus einer Schmelze bei geringeren Temperaturen als in reinen Festkörperreaktionen erzeugt wird, wodurch das Abdampfen von für die Schichtbildung notwendigen Elementen unterdrückt wird.

Da in dem erfindungsgemäßen Verfahren eine Texturierung bei niedrigeren Temperaturen als der Schmelztemperatur der Schicht erfolgt, sind lange Temperungszeiten zulässig. Durch die geringere Reaktionstemperatur wird ein Abdampfen von Material aus der Schicht vermindert.

Es liegt im Rahmen der Erfindung, die kristallographischen und elektrischen Eigenschaften der surpraleitenden Schicht durch mehrmaliges Nachtempern und Abkühlen zu verbessern.

Es liegt ferner im Rahmen der Erfindung, daß bei der Kristallisation eine Orientierung der gebildeten Kristallite in einer auf einem Substrat befindlichen, flächigen Schmelze erfolgt.

In einer Ausführungsform wird auf dem Substrat eine Schicht erzeugt, die eine Mischung aus Grundsubstanzen für die Keramikschicht und einem Salz enthält. Dabei hat das Salz die Eigenschaft, daß es in der Mischung eine geringere Schmelztemperatur als im Reinzustand hat und daß die Schmelztemperatur des Salzes in der Mischung geringer als die Zersetzungstemperatur der vorgegebenen Phasen ist. Die Schicht wird auf eine Reaktionstemperatur erhitzt, bei der das Salz eine flüchtige Schmelze bildet und die unter der Zersetzungstemperatur der vorgegebenen Phasen liegt. In der Schmelze erfolgt die Orientierung der wachsenden Kristallite. Da das Salz in der Schmelze flüchtig ist, verdampft es beim Ausbilden der texturierten, supraleitenden Keramikschicht. Die Schicht muß daher genügend Salz enthalten, damit sich die für die Orientierung der Kristallite nötige Schmelze ausbilden kann. Sollte das Salz während des Temperaturprozesses bei der Reaktionstemperatur noch nicht vollständig verdampft sein, wird es durch nachfolgendes Tempern durch vollständiges Verdampfen entfernt.

Die Verwendung von Salzschmelzen zur Förderung der Reaktion und des Kristallwachstums bei dielektrischen Keramiken ist aus K. Katayama et al., Ceramics International, 15 (1989) Seiten 289 bis 295 bekannt. Pulver für eine Pb $(Mg_{1/3}Nb_{2/3})O_3$-Keramik wird durch Schmelzung einer Mischung aus Oxidpulvern (PbO, MgO, $Nb_2O_5$) und dem Salz KCl hergestellt. Nach dem Erstarren der Schmelze wird das Salz KCl in kochender, verdünnter Salpetersäure ausgewaschen. Die Verwendung der Salzschmelze dient hier der Förderung der Durchmischung der Rohmaterialien.

Bei der Herstellung texturierter, supraleitender Keramikschichten erfolgt die Ausrichtung der Kristallite bei der Kristallisation des Schichtmaterials aus der Schmelze. Die Schmelze sorgt dabei für optimalen Wärme- und Stofftransport. Die Erfindung macht sich die Erkenntnis zunutze, daß optimaler Wärme- und Stofftransport auch durch eine Schichtmaterial-fremde Schmelze erfolgen kann.

Auf dem Substrat wird eine Schicht erzeugt, die aus einer Mischung der unter Umständen vorreagierten Grundsubstanzen für die supraleitende Keramik und einem Salz besteht. In dieser Mischung hat das Salz eine niedrigere Schmelztemperatur als im Reinzustand und als es der Zersetzungstemperatur der Vorgegebenen Phasen entspricht. In dieser Schmelze kommt es zur Ausbildung von Kristalliten, die mit ihrer kristallographischen c-Achse senkrecht zur Oberfläche des Substrats ausgerichtet sind.

Das Salz wird so gewählt, daß es bei der Reaktionstemperatur flüchtig ist. Es dampft daher von der flächigen Schichtprobe ab, so daß eine Schicht aus orientierten Supraleiterkristalliten zurückbleibt.

Da das Salz bei geringeren Temperaturen schmilzt als eine bereits reagierte Schicht, ist es möglich, dicke, texturierte, supraleitende Keramikschichten dadurch herzustellen, daß das beschriebene Verfahren mehrfach angewandt wird: Auf eine fertige texturierte, supraleitende Keramikschicht wird wiederum eine Schicht aus der Mischung der Grundsubstanzen und des Salzes aufgebracht. Diese wird durch Aufheizen auf die Reaktionstemperatur in eine weitere, texturierte, supraleitende Keramikschicht umgewandelt. Bei diesem erneuten Temperaturschritt werden eventuell in der zuvor gefertigten Schicht vorhandene Löcher und Gräben geschlossen. Dabei wird die Dicke der supraleitenden Schicht insgesamt vergrößert.

Als Salz sind insbesondere die Alkalisalze geeignet.

Das erfindungsgemäße Herstellverfahren eignet sich insbesondere zur Herstellung von Bi-Pb-Sr-Ca-Cu-Oxid-Keramik, Y-Ba-Ca-Cu-Oxid Keramik sowie Tl-Ba-Ca-Cu-Oxid Keramik.

Es liegt im Rahmen der Erfindung, durch gezieltes Tempern der fertigen, texturierten, supraleitenden Keramikschicht eine supraleitende Phase zu verstärken. Ein solcher Temperschritt ist aus der Veröffentlichung von B. Seebacher et al., Proc. of the 1st European Ceramic Society Meeting 1989 in Maastricht, Vol. 2 p. 456 bis 460 bekannt.

Weitere Ausgestaltungen der Erfindung gehen aus den übrigen Ansprüchen hervor.

Im folgenden wird die Erfindung anhand der Figuren und von Ausführungsbeispielen genauer erläutert.

Figur 1     zeigt ein Substrat mit einer Schicht aus einer Mischung der Grundsubstanzen der Keramik und des Salzes.

Figur 2     zeigt das Substrat mit der fertigen texturierten, supraleitenden Keramikschicht.

Figur 3     zeigt das Substrat mit der darauf angeordneten texturierten, supraleitenden Keramikschicht, auf eine

weitere Schicht aus der Mischung aus den Grundsubstanzen der Keramik und dem Salz aufgebracht wurde.

Figur 4     zeigt das Substrat mit einer dicken, texturierten, supraleitenden Keramikschicht.

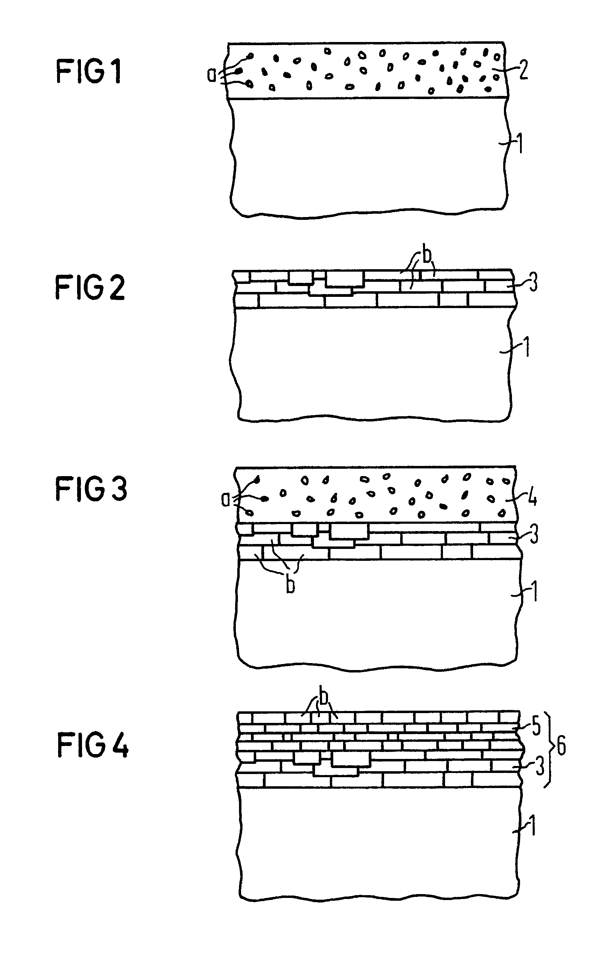

Auf ein Substrat 1, das zum Beispiel aus Magnesiumoxid oder Circonoxid (einkristallin oder polykristallin) besteht, wird eine Schicht 2 aufgebracht (siehe Figur 1). Die Schicht 2 besteht aus einer Mischung aus unter Umständen vorreagierten Grundsubstanzen für die supraleitende Keramikschicht (angedeutet durch das Bezugszeichen a) und einem Salz. Die Schicht 2 wird zum Beispiel in einem Siebdruckverfahren erzeugt. Die Schicht 2 wird auf eine Reaktionstemperatur erhitzt, die größer ist als die Schmelztemperatur des Salzes in der Mischung und die geringer ist als die Zersetzungstemperatur der vorgegebenen Phasen der supraleitenden Keramik. Bei der Reaktionstemperatur ist die Schmelze des Salzes flüchtig. In der Schmelze der Mischung findet ein Wärme- und Stofftransport statt. Gleichzeitig verdampft die Salzschmelze aus der Schicht. Es bilden sich orientierte Supraleiterkristallite (angedeutet durch das Bezugszeichen b) in zusammenhängender Schicht 3 aus (s. Figur 2). Die Salzschmelze ist während des Temperaturprozesses beziehungsweise bei nachfolgenden Temperungen vollständig verdampft.

Zur Erzeugung dickerer, texturierter, supraleitender Schichten wird auf die fertige supraleitende Schicht 3 eine weitere Schicht 4 aus der Mischung aus den Grundsubstanzen für die supraleitende Keramik und dem Salz aufgebracht (siehe Figur 3). Durch Erhitzen der Struktur auf die Reaktionstemperatur, bei der die weitere Schicht 4 eine Schmelze bildet, werden eventuell in der supraleitenden Schicht 3 vorhandene Löcher und Gräben gefüllt und die Gesamtschichtdicke um die Dicke einer weiteren texturierten, supraleitenden Schicht 5 (siehe Figur 4) erhöht. Die supraleitende Schicht 3 und die supraleitende Schicht 5 bilden gemeinsam eine dicke supraleitende Schicht 6.

In einem Ausführungsbeispiel wird eine texturierte, supraleitende Keramikschicht aus Bi-Pb-Sr-Ca-Cu-Oxid erzeugt. Als Grundsubstanzen werden $Bi_2O_3$, PbO, $SrCO_3$, $CaCO_3$ und CuO in folgender Zusammensetzung 1,6:0,4:2:2:3 verwendet. Als Salz wird z. B. KCl verwendet. Die Mischung aus den Keramikgrundsubstanzen und dem Salz wird auf eine Reaktionstemperatur von 850 °C erhitzt. Bei dieser Temperatur verdampft KCl aus der Schicht 2. Um eine optimale Durchmischung der Grundsubstanzen zu erzielen, wird die Schmelze kurze Zeit auf der Reaktionstemperatur gehalten. Bei dem anschließenden Abkühlen entsteht eine texturierte, supraleitende Keramikschicht. Eine vorgegebene supraleitende Phase wird anschließend durch Nachtempern verstärkt. Bei dem Nachtempern verdampft ein gegebenenfalls vorhandener Rest des Salzes aus der Keramikschicht.

Das erfindungsgemäße Verfahren läßt sich Analog zur Herstellung von texturierten, supraleitenden Keramikschichten aus Y-Ba-Ca-Cu-Oxid oder Tl-Ba-Ca-Cu-Oxid verwenden.

**Patentansprüche**

1. Verfahren zur Herstellung einer texturierten, supraleitenden Keramikschicht vorgegebener Phasen, bei dem die supraleitende Keramikschicht durch Kristallisation aus einer Schmelze bei geringeren Temperaturen als in reinen Festkörperreaktionen erzeugt wird, wodurch das Abdampfen von für die Schichtbildung notwendigen Elementen unterdrückt wird.

2. Verfahren nach Anspruch 1,
   **dadurch gekennzeichnet**, daß die kristallographischen und elektrischen Eigenschaften der supraleitenden Schicht (3) durch mehrmaliges Nachtempern und Abkühlen verbessert werden.

3. Verfahren nach Anspruch 1 oder 2,
   **dadurch gekennzeichnet**, daß bei der Kristallisation eine Orientierung der gebildeten Kristallite in einer auf einem Substrat (1) befindlichen, flächigen Schmelze erfolgt.

4. Verfahren nach Anspruch 3 mit folgenden Schritten:
   a) auf einem Substrat (1) wird eine Schicht (2) erzeugt, die eine Mischung aus Grundsubstanzen für die Keramikschicht (3) und einem Salz mit der Eigenschaft enthält, daß das Salz in der Mischung eine geringere Schmelztemperatur als im Reinzustand hat und daß die Schmelztemperatur des Salzes in der Mischung geringer als die Zersetzungstemperatur der vorgegebenen Phasen ist,
   b) die Schicht (2) wird auf eine Reaktionstemperatur erhitzt, bei der das Salz eine flüchtige Schmelze bildet und die unter der Zersetzungstemperatur der vorgegebenen Phasen liegt.

5. Verfahren zur Herstellung einer texturierten, supraleitenden Keramikschicht vorgegebener Dicke nach Anspruch 4 mit folgenden Schritten:
   a) nach der Herstellung einer ersten texturierten, supraleitenden Keramikschicht (3) wird auf der Oberfläche der Struktur eine weitere Schicht (4) aus der Mischung erzeugt, die durch Aufheizen auf die Reaktionstemperatur in eine weitere, texturierte supraleitende Keramikschicht (5) verwandelt wird,
   b) dieses Vorgehen wird solange wiederholt, bis die aus der ersten texturierten, supraleitenden Keramikschicht und den darauf aufgewachsenen, weiteren texturierten, supraleitenden Keramikschichten gebildete texturierte, supraleitende Keramikschicht (6) die vorgegebene Dicke aufweist.

6. Verfahren nach Anspruch 4 oder 5, **dadurch gekennzeichnet**, daß als Salz ein Alkalisalz verwendet wird.

7. Verfahren nach einem der Ansprüche 4 bis 6, **dadurch gekennzeichnet**, daß die Grundsubstanzen für eine Bi-Pb-Sr-Ca-Cu-Oxid-Keramik, eine Y-Ba-Ca-Cu-Oxid-Keramik oder eine Tl-Ba-Ca-Cu-Oxid-Keramik verwendet werden.

8. Verfahren nach einem der Ansprüche 4 bis 7, **dadurch gekennzeichnet**, daß in der texturierten, supraleitenden Keramikschicht durch Tempern eine vorgegebene, supraleitende Phase verstärkt wird.

9. Verfahren nach einem der Ansprüche 4 bis 8, **dadurch gekennzeichnet**, daß die Grundsubstanzen für eine Bi-Pb-Sr-Ca-Cu-Oxid-Keramik verwendet werden, daß als Salz KCl verwendet wird und daß die Reaktionstemperatur im Bereich von 800 - 880 °C liegt.

10. Verfahren nach einem der Ansprüche 4 bis 8, **dadurch gekennzeichnet**, daß die Grundsubstanzen für eine Y-Ba-Ca-Cu-Oxid-Keramik verwendet werden, daß als Salz KCl und/oder NaCl verwendet wird und daß die Reaktionstemperatur im Bereich von 900 - 960 °C liegt.

FIG 1

FIG 2

FIG 3

FIG 4

Europäisches
Patentamt

EUROPÄISCHER
RECHERCHENBERICHT

Nummer der Anmeldung

EP 90 10 7695

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | JAPANESE JOURNAL OF APPLIED PHYSICS, Band 28, Nr. 9, September 1989, Seiten L1571-L1574, Tokyo, JP; H. TAKEYA et al.: "Preparation of high-Tc Bi-Sr-Ca-Cu-O films on MgO substrates by the method of solvent evaporation epitaxy (SEE)" * Seite L1571, Absätze 2-7 * | 1,3-4,6-7, 9 | H 01 L 39/24 |
| X | APPLIED PHYSICS LETTERS, Band 54, Nr. 20, 15. Mai 1989, Seiten 2041-2042, New York, US; G. BALESTRINO et al.: "Growth of textured films of Bi2Sr2CaCu2O8 + x from KC1 solution" * Seite 2041 * | 1,3-4,6-7, 9 | |
| A | MATERIALS LETTERS, Band 8, Nr. 10, Oktober 1989, Seiten 432-435, Amsterdam, NL; K.W. GOEKING et al.: "Single-phase synthesis of Bi-Ca-Sr-Cu-O oxides by high temperature solution growth technique" * Seite 432; Seite 433, Absätze 2-5 * | 1,4,6-7,9 | |
| A | NATURE, Band 332, 31. März 1988, Seiten 422-424, Basingstoke, GB; L.F. SCHNEEMEYER et al.: "Growth of superconducting single crystals in the Bi-Sr-Ca-Cu-O system from alkali chloride fluxes" * Seite 423, Absätze 2-3 * | 1,4,6-7,9 | RECHERCHIERTE SACHGEBIETE (Int. Cl.5)  H 01 L 39 |

Der vorliegende Recherchenbericht wurde für alle Patentansprüche erstellt

| Recherchenort | Abschlußdatum der Recherche | Prüfer |
|---|---|---|
| Den Haag | 07 März 91 | HAMMEL E.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument